# EUROPEAN PATENT APPLICATION

(11) **EP 4 693 348 A1**
(43) Date of publication of application: **11.02.2026**
(21) Application number: 24780994.0
(22) Date of filing: 26.01.2024
(51) Int. Cl.: H01F 5/02, H01F 27/06, H01F 27/02, H02M 3/00

(54) **POWER CONVERSION APPARATUS**

(30) Priority: 29.03.2023 KR 20230041550; 13.04.2023 KR 20230049032
(71) Applicant: LG INNOTEK CO. LTD, Gangseo-gu Seoul 07796 (KR)
(72) Inventor: YOON, Dong Keun, Seoul 07796 (KR); LEE, Seung Min, Seoul 07796 (KR); JUNG, Kwang Soon, Seoul 07796 (KR)
(74) Representative: Plasseraud IP
(86) International application number: PCT/KR2024/001255
(87) International publication number: WO 2024/204999

(57) **Abstract**

A transformer according to an embodiment of the present invention comprises: a bobbin; a coil wound around the bobbin; and a core surrounding the coil and the bobbin, wherein the bobbin comprises an upper portion, a lower portion, and a middle portion which is between the upper and lower portions and around which the coil is wound, and holes are provided in the lower portion of the bobbin.

## Description

### [Technical Field]

The present invention relates to a power conversion apparatus.

### [Background Art]

Generally, an eco-friendly vehicle is a vehicle equipped with a power source consisting of a drive motor that is powered by an engine and/or a battery. Accordingly, it is referred to as a vehicle that can improve its fuel efficiency during starting and/or acceleration through the power assist of the motor, which is operated by the battery's voltage, by applying a structure that appropriately combines this power source to the front wheels.

In eco-friendly vehicles, a power conversion apparatus (LDC: Low DC/DC Converter) is installed to rectify power from a high-voltage battery into direct current (DC). The power conversion apparatus switches the DC to create an alternating current (AC), which is then stepped up or down using components such as coils, transformers, and capacitors. Afterward, it is rectified back into DC and serves to supply electricity at a voltage suitable for each electrical load.

### [Detailed Description of the Invention]

### [Technical Subject]

The technical problem to be solved by the present invention is to provide a power conversion apparatus.

### [Technical Solution]

In order to solve the above technical problems, a transformer according to an embodiment of the present invention comprises: a bobbin; a coil being wound around the bobbin; and a core surrounding the coil and the bobbin, wherein the bobbin comprises an upper portion, a lower portion, and a middle portion which is between the upper and lower portions and around which the coil is wound, and holes are provided in the lower portion of the bobbin.

The lower portion of the bobbin may include a recessed portion in which the hole is formed, and the recessed portion may include a plurality of recessed portions being formed spaced apart from an edge of the lower portion of the bobbin.

The upper portion of the bobbin includes an upper surface facing the core and a protruded portion being protruded outward from the upper surface, and the protruded portion can be overlapped with the coil from the upper portion toward the lower portion.

The hole may not be overlapped with the protruded portion in a direction from the upper portion to the lower portion.

The upper portion of the bobbin includes a guide wall being protrudedly formed between the upper surface and the protruded portion, and an inner surface of the guide wall can face the core.

In order to solve the above technical problems, a power conversion apparatus according to the present embodiment includes: a first housing; a first substrate being disposed in the first housing; and a transformer being disposed on the first substrate, wherein the transformer includes: a bobbin including a hollow portion; a coil being wound around the bobbin; and a core being disposed to surround the coil and the bobbin, wherein the bobbin includes an upper portion, a lower portion, and a middle portion on which the coil is wound between the upper portion and the lower portion, and wherein the transformer can be coupled to the first housing as a screw is disposed in a hole being formed in the lower portion of the bobbin.

A fixing member is inserted from the outside to the inside of the first housing, and the screw being disposed in the hole of the bobbin can be combined with the fixing member.

It may include: a second housing being coupled to the first housing; and a second substrate being disposed in the second housing, wherein the second substrate may include a support member being disposed at a position corresponding to the transformer.

The support member includes a first pad being disposed on the second substrate and a second pad being disposed on the first pad, and the second pad may be made of an elastic material or a sponge material.

The upper portion of the bobbin includes an upper surface facing the core and a protruded portion being protruded outward from the upper surface, and the protruded portion can be overlapped with the coil from the upper portion toward the lower portion.

The hole of the bobbin may not be overlapped with the protruded portion in a direction from the upper portion to the lower portion.

The upper portion of the bobbin includes a guide wall being protruded between the upper surface and the protruded portion, and an inner surface of the guide wall can face the core.

### [Advantageous Effects]

According to the present embodiments, a bulky transformer can be coupled to a housing to minimize warping of the substrate, and the influence of vertical vibration can be reduced through a support member.

In addition, heat dissipation performance can be improved by placing the heat generating component in an area being overlapped with the fan module, and air circulation can be concentrated on the heat sink by placing components on both side surfaces of the heat sink and structures at the front and rear.

In addition, space efficiency can be improved by allowing additional components to be disposed by forming a gap in the lower portion of the switching module.

In addition, by symmetrically placing each component with respect to the heatsink, it is possible to optimize the circuit design and balance the weight.

In addition, by integrating a plurality of switching device units into a single heatsink, it is possible to lower the maximum temperature of components within the switching module and achieve thermal equilibrium, thereby optimizing heat dissipation performance.

### [Brief Description of Drawings]

FIG. 1 is a perspective view of a power conversion apparatus according to the present embodiment.
FIG. 2 is an exploded perspective view of a power conversion apparatus according to the present embodiment.
FIG. 3 is an exploded perspective view of a power conversion apparatus according to the present embodiment.
FIG. 4 is a drawing of a first assembly according to the present embodiment.
FIG. 5 is a drawing of a second assembly according to the present embodiment.
FIG. 6 is a front view of a first switching module according to the present embodiment.
FIG. 7 is a perspective view of a first switching module according to the present embodiment.
FIG. 8 is a perspective view of a fourth switching module according to the present embodiment.
FIG. 9 is a perspective view of the fourth switching module viewed from a different angle than that of FIG. 8.
FIG. 10 is a perspective view of a transformer according to the present embodiment.
FIG. 11 is a perspective view of a bobbin according to the present embodiment.
FIG. 12 is a drawing illustrating an arrangement of a transformer according to the present embodiment.
FIG. 13 is a drawing of first and second assemblies according to the present embodiment.
FIG. 14 is a cross-sectional view taken along line A of FIG. 13.
FIG. 15 is a cross-sectional view taken along line B of FIG. 13.
FIG. 16 is a partial drawing of a second assembly according to the present embodiment.
FIG. 17 is a partial drawing of a second assembly according to the present embodiment.

### [BEST MODE]

Hereinafter, preferred embodiments of the present invention will be described in detail with reference to the accompanying drawings.

However, the technical idea of the present invention is not limited to some embodiments to be described, but may be implemented in various forms, and inside the scope of the technical idea of the present invention, one or more of the constituent elements may be selectively combined or substituted between embodiments.

In addition, the terms (including technical and scientific terms) used in the embodiments of the present invention, unless explicitly defined and described, can be interpreted as a meaning that can be generally understood by a person skilled in the art, and commonly used terms such as terms defined in the dictionary may be interpreted in consideration of the meaning of the context of the related technology.

In addition, terms used in the present specification are for describing embodiments and are not intended to limit the present invention. In the present specification, the singular form may include the plural form unless specifically stated in the phrase, and when described as "at least one (or more than one) of A and B and C", it may include one or more of all combinations that can be combined with A, B, and C.

In addition, in describing the components of the embodiment of the present invention, terms such as first, second, A, B, (a), and (b) may be used.

These terms are merely intended to distinguish the components from other components, and the terms do not limit the nature, order or sequence of the components.

And, when a component is described as being 'connected', 'coupled' or 'interconnected' to another component, the component is not only directly connected, coupled or interconnected to the other component, but may also include cases of being 'connected', 'coupled', or 'interconnected' due that another component between that other components.

In addition, when described as being formed or disposed in "on (above)" or "below (under)" of each component, "on (above)" or "below (under)" means that it includes not only the case where the two components are directly in contact with, but also the case where one or more other components are formed or disposed between the two components. In addition, when expressed as "on (above)" or "below (under)", the meaning of not only an upward direction but also a downward direction with respect to one component may be included.

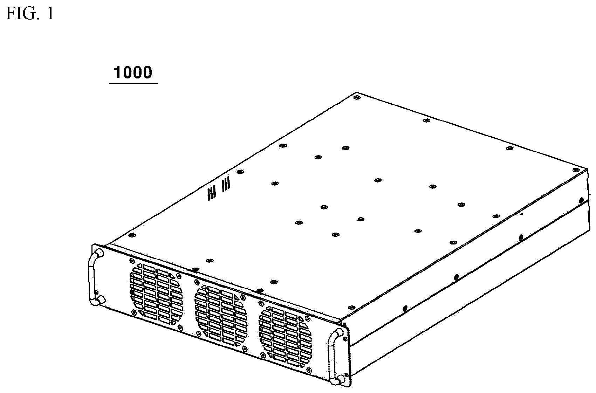

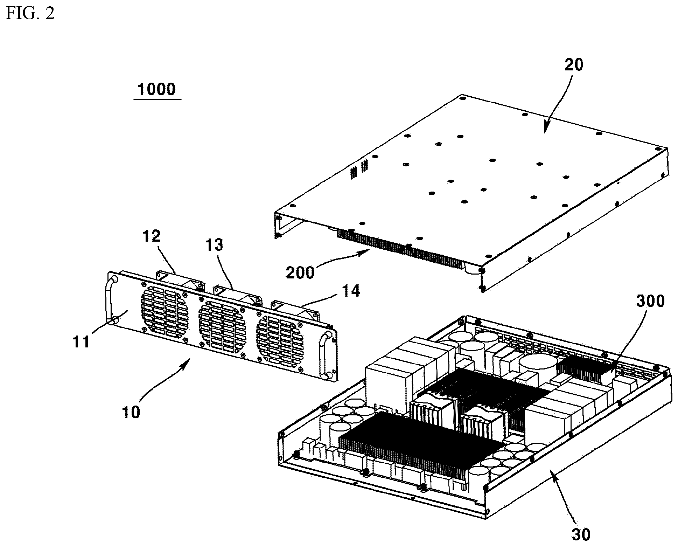

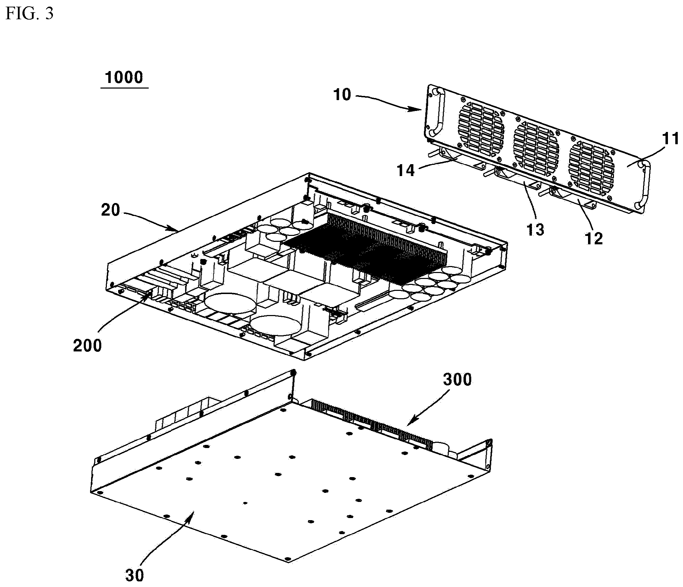

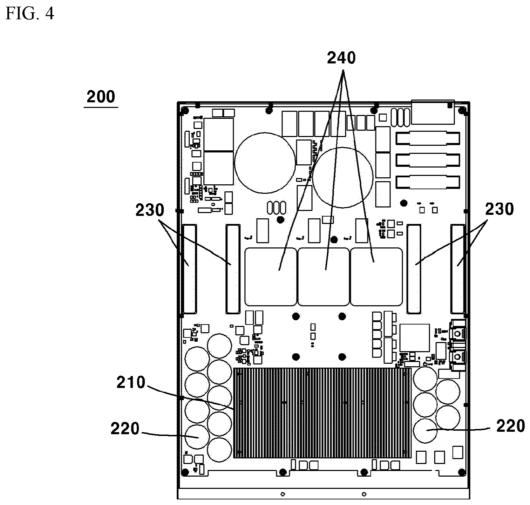

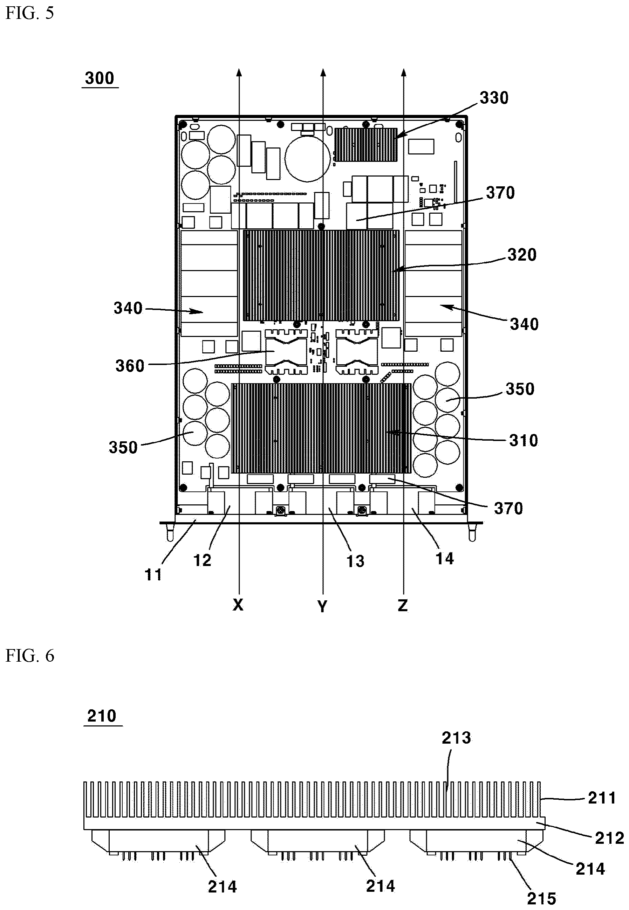

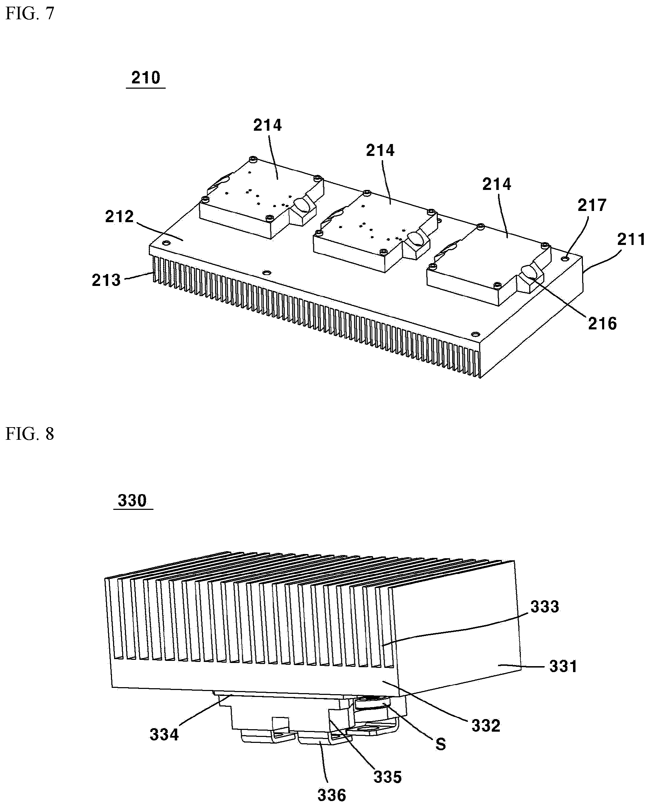

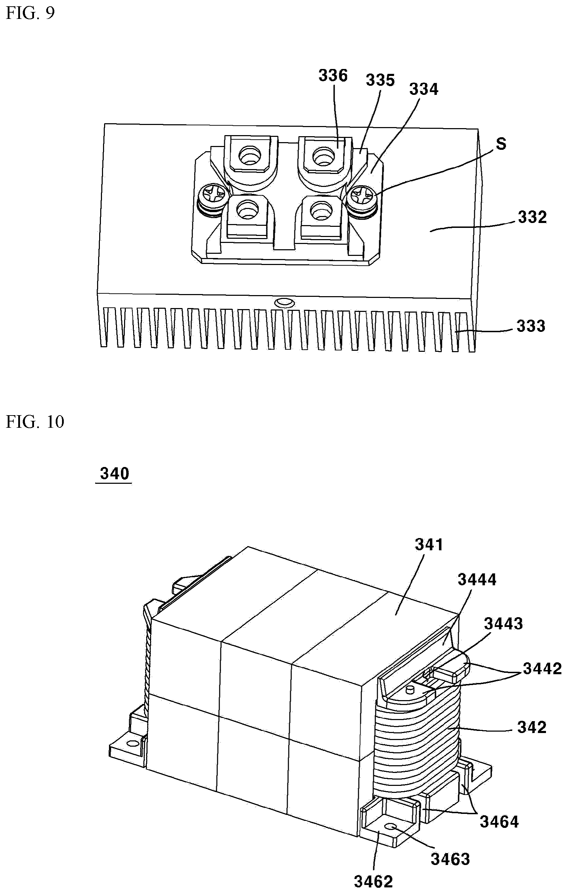

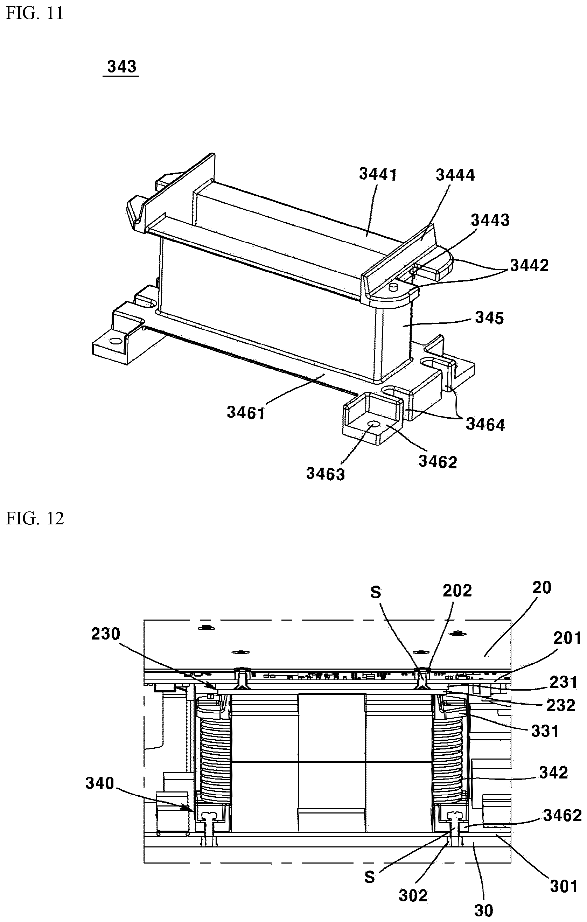

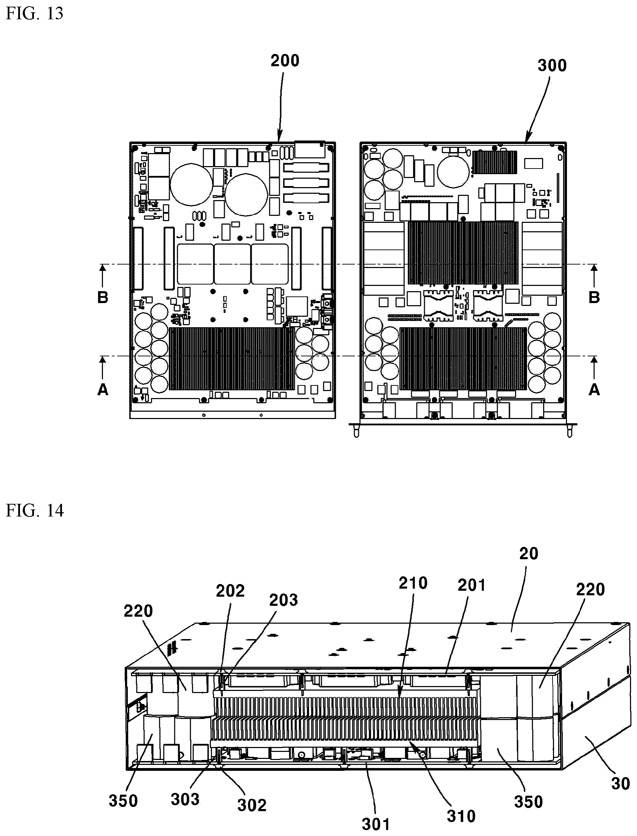

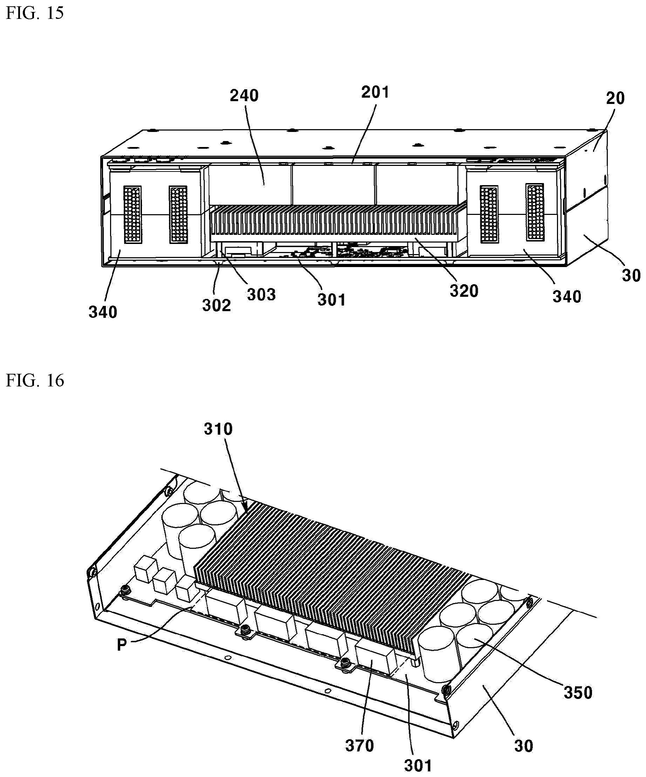

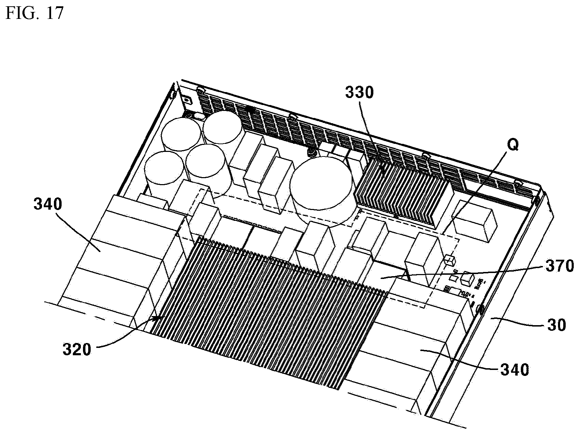

FIG. 1 is a perspective view of a power conversion apparatus according to the present embodiment; FIG. 2 is an exploded perspective view of a power conversion apparatus according to the present embodiment; FIG. 3 is an exploded perspective view of a power conversion apparatus according to the present embodiment; FIG. 4 is a drawing of a first assembly according to the present embodiment; FIG. 5 is a drawing of a second assembly according to the present embodiment; FIG. 6 is a front view of a first switching module according to the present embodiment; FIG. 7 is a perspective view of a first switching module according to the present embodiment; FIG. 8 is a perspective view of a fourth switching module according to the present embodiment; FIG. 9 is a perspective view of the fourth switching module viewed from a different angle than that of FIG. 8; FIG. 10 is a perspective view of a transformer according to the present embodiment; FIG. 11 is a perspective view of a bobbin according to the present embodiment; FIG. 12 is a drawing illustrating an arrangement of a transformer according to the present embodiment; FIG. 13 is a drawing of first and second assemblies according to the present embodiment; FIG. 14 is a cross-sectional view taken along line A of FIG. 13; FIG. 15 is a cross-sectional view taken along line B of FIG. 13; FIG. 16 is a partial drawing of a second assembly according to the present embodiment; and FIG. 17 is a partial drawing of a second assembly according to the present embodiment.

The power conversion apparatus **1000** according to the present embodiment may include a fan module 10, a first assembly 200 being disposed in a first housing 20, and a second assembly 300 being disposed in a second housing 30.

The power conversion apparatus **1000** according to the present embodiment may be a power module. The power conversion apparatus **1000** may be a power supply unit (PSU). The power conversion apparatus **1000** may be a power circuit device that generates required output power from input power. The power conversion apparatus **1000** may be a device that supplies power required for charging a battery, and may be a device that converts input commercial AC power into DC power required by a battery and outputs it.

The power conversion apparatus **1000** may comprise an EMI (Electromagnetic Interference) filter being connected to AC power being supplied to the power conversion apparatus, a PFC (Power Factor Correction) unit being connected to the EMI filter, and a DC/DC converter unit being connected to the PFC unit. Specifically, the EMI filter can remove noise from the AC power. The PFC unit matches the voltage and rectification of the AC power rectified by the EMI filter to be in-phase. The PFC unit may be referred to as an AC/DC converter unit. The PFC unit boosts the input power after improving the power factor. Thereafter, the DC/DC converter unit converts the power into DC power that meets the specifications of the load being supplied with the power.

The power conversion apparatus **1000** may include components such as a fan module, an EMI filter, an AC socket, a PFC section, a DC-DC converter unit, and a flyback converter, and each component may influence each other depending on the size and mounting position of each component. Accordingly, the overall size of the power conversion apparatus **1000** may vary.

The fan module **10** may be disposed in front of the power conversion apparatus **1000.** The fan module **10** may be disposed on one side of the power conversion apparatus **1000.** The fan module **10** may cool components being disposed at one side of the power conversion apparatus **1000.** A ventilation hole may be disposed at the rear of the power conversion apparatus **1000,** opposite to where the fan module **10** is disposed. As the fan module **10** operates, external air may be introduced into the interior to cool components that generate heat. The direction connected from the fan module **10** to the ventilation hole may be referred to as a first direction. The direction perpendicular to the first direction may be referred to as a second direction.

The fan module **10** may include at least one fan being disposed in the panel **11.** The fan module **10** may include first to third fans **12, 13** and **14** being disposed in a row on the panel **11.** The first to third fans **12, 13** and **14** may be disposed spaced apart from one another. The first to third fans **12, 13** and **14** may be disposed sequentially. The second fan **13** may be disposed between the first fan **12** and the third fan **14.** The second fan **13** may be disposed at the center portion of the panel **11.** The first fan **12** may be disposed closer to the second fan **13** than the side plates of the first housing **20** and the second housing **30.** The third fan **14** may be disposed closer to the second fan **13** than the side plates of the first housing **20** and the second housing **30.** The first fan **12** and the second fan **13,** and the second fan **13** and the third fan **14** may be disposed at equal intervals.

The second assembly **300** may be disposed in the second housing **30.** The second housing **30** may include a lower plate on which the second assembly **300** is disposed, and two side plates being extended vertically from both side surfaces of the lower plate. Components constituting a DC/DC converter unit may be disposed in the second assembly **300.** The second assembly **300** may receive DC power from the first assembly **200,** convert the DC power into power suitable for charging the battery, and output the converted power to the battery.

The power conversion apparatus **1000** may have an overall hexahedral shape in which the side plates of the first housing **20** and the second housing **30** are connected to each other and a fan module **10** is disposed at the front. However, the present invention is not limited thereto, and the shape of the power conversion apparatus **1000** may be modified in various ways. In the power conversion apparatus **1000,** the first assembly **200** and the second assembly **300** may be disposed to face each other. The components disposed in the first assembly **200** and the components being disposed in the second assembly 300 may be disposed to face each other.

The first assembly **200** may be an assembly in which components constituting an AC/DC converter unit are disposed on a first substrate **201.** The components being disposed on the first substrate **201** may include a first switch module **210,** a first capacitor **220,** an inductor **240,** a support member **230,** and may include an input terminal, an EMI filter, and the like.

The first switch module **210** may be disposed closest to the fan module **10.** An inductor **240** may be disposed at the rear of the first switch module **210.** Since the first switch module **210** and the inductor **240** are components that generate heat among the components included in the first assembly **200,** they may be disposed closest to the fan module **10.** Since the plurality of fans included in the fan module **10** are densely disposed in the central portion, the heat-generating components included in the first assembly **200** may be disposed in a direction facing the fans being disposed in the central portion. Through this, the heat dissipation effect can be increased by intensively generating air circulation in the central portion where the heat-generating components are disposed.

A virtual line X connecting from the center of the first fan **12** to the ventilation hole, a virtual line Y connecting from the center of the second fan **13** to the ventilation hole, and a virtual line Z connecting from the center of the third fan **14** to the ventilation hole may be defined. The first switch module **210** can be overlapped with at least two among the virtual lines X, Y, and Z. The plurality of inductors **240** can be overlapped with at least two among the virtual lines X, Y, and Z. The first switch module **210** can be disposed to be overlapped with at least two fans in the first direction connecting the fan module **10** and the ventilation hole. The plurality of inductors **240** may be disposed to be overlapped with at least two fans in the first direction connecting the fan module **10** and the ventilation hole.

First capacitors **220** may be disposed on both sides of the first switch module **210.** The first capacitors **220** may be disposed in multiple rows to serve as barriers to concentrate air flow on the first switch module **210.** For example, the first capacitors **220** may be disposed in two rows, but may be disposed in an alternating manner.

On both sides of the inductor **240,** a support member **230** that supports a transformer **340** of a second assembly **300** to be described later may be disposed. By combining the first housing **20** and the second housing **30,** the transformer **340** of the second assembly **300** is disposed on both sides of the inductor **240,** and the transformer **340** of the second assembly **300** can serve as a barrier to concentrate the air flow on the inductor **240.**

Referring to FIGS. 6 and 7, the first switch module **210** may include a heat sink **211** and a device unit **214.** Although the heat sink **211** and the device unit **214** are described as a single component forming the first switch module **210,** the heat sink **211** and the device unit **214** may each be separate configurations. The first switch module **210** may be formed with the same configuration as the second switch module **310** and the third switch module **320.**

The number of device units being disposed on the heat sink of the first to third switching modules **210, 310** and **320** may vary depending on the size. Since the configurations included in the first to third switching modules **210, 310** and **320** may be the same, the description of the second and third switching modules **310** and **320** is omitted, as the description of the first switching module **210** will apply to them as well.

The heat sink **211** may include a base **212** on which a device unit **214** is placed on one surface, and heat dissipation fins **213** protrudingly formed on the other surface of the base **212.** A plurality of heat dissipation fins **213** may be formed parallel to each other to form a flow path through which air may flow in a recessed area. The flow path formed between the plurality of heat dissipation fins **213** may be formed in a straight line from the fan module **10** to the ventilation hole. The plurality of heat dissipation fins **213** may be formed to be extended in a first direction. The plurality of heat dissipation fins **213** may be formed parallel to each other. A plurality of grooves formed between the plurality of heat dissipation fins **213** may be formed parallel to each other.

One surface of the base **212** may include a spacer hole **217** to which a spacer **203** is coupled. The spacer **203** may be disposed in the spacer hole **217** and fixed by a pop nut **202** being inserted from the outer surface of the first housing **20.** The spacer **203** may be disposed in the spacer hole **217** and fixed by a screw being inserted from the outer surface of the first substrate **201.** The spacer **203** may be disposed at an edge of one surface of the base **212** and may support the first switch module **210.**

When the first switch module **210** is disposed on the first substrate **201,** the spacer **203** can support the first switch module **210** so that a gap is formed between one surface of the base **212** and the first substrate **201.** Additional components can be disposed in the gap formed between one surface of the base **212** and the first substrate **201.** Additional components can be disposed in the gap where the device unit **214** is not disposed between one surface of the base **212** and the first substrate **201.**

The device unit **214** can be disposed on one surface of the base **212.** A plurality of device units **214** can be disposed spaced apart from one another on one surface of the base **212.** The device unit **214** may include a frame and a plurality of switching elements being mounted inside the frame. The frame of the device unit **214** can be made of an insulating material. Various switching elements and rectifier diodes can be mounted on the device unit **214.** The switching elements included in the device unit **214** can secure an insulating distance by being disposed inside the frame made of an insulating material.

By arranging multiple device units **214** on a single heat sink **211,** the heat being generated from the device units **214** can be integrated and managed. From the perspective of thermal management of the power conversion apparatus **1000,** it may be more stable for the temperature of the entire device unit to increase rather than for a single device unit to overheat. This has the effect of lowering the maximum heat generation temperature being generated from multiple device units.

One surface of the device unit **214** may include a plurality of pins **215** connected to the first substrate **201.** A plurality of switches of the device unit **214** may be electrically connected to the first substrate **201** through the plurality of pins **215.** The device unit **214** may include a coupling hole **216.** The frame of the device unit **214** may include the coupling hole **216.** The device unit **214** may be coupled to the heat sink **211** through a screw being coupled to the coupling hole **216.**

Referring to the **P** area of FIG. 16 and the **Q** area of FIG. 17, at least one structure **370** may be disposed on one or the other side of the switching module in a first direction connecting the fan module **10** and the ventilation hole. The structure may be disposed in a direction facing the fan module **10** in the switching module being disposed closest to the fan module **10.** The structure may be disposed in a direction facing the ventilation hole in the switching module being disposed farthest from the fan module **10.** Here, the structure may be an electronic component or element, and may be, for example, a film capacitor.

The structure **370** can prevent air from flowing through the gap between the base **212** and the first substrate **201** and focus air circulation by the fan module **10** on the heat sink **211.** The height of the structure **370** from the first substrate **201** can be greater than the spacer **203** and less than the base **212.** By appropriately arranging structures **370** having various heights, air circulation can be focused on the switching module.

The second assembly **300** may be an assembly in which components constituting a DC/DC converter unit are disposed on a second substrate **301.** The components being disposed on the second substrate **301** may include a second switch module **310,** a third switch module **320,** a fourth switch module **330,** a transformer **340,** a second capacitor **350,** a heat generating component **360,** and a structure **370.**

The second switch module **310** may be disposed closest to the fan module **10.** The third switch module **320** may be disposed at the rear of the second switch module **310.** A heat generating component **360** may be disposed between the second switch module **310** and the third switch module **320.** Here, the heat generating component **360** may be a resonant inductor. The fourth switch module **330** may be disposed at the rear of the third switch module **320.**

The second to fourth switching modules **310, 320** and **330** are components that generate heat among the components included in the second assembly **300,** and thus can be disposed adjacent to the fan module **10.** Since the plurality of fans included in the fan module **10** are densely disposed in the central portion, the heat-generating components included in the second assembly **300** can be disposed in a direction facing the fans being disposed in the central portion. Through this, the heat dissipation effect can be enhanced by intensively generating air circulation in the central portion where the heat-generating components are disposed.

The second switch module **310,** the third switch module **320,** and the heat generating component **360** may be overlapped with at least two among the virtual lines X, Y, and Z. The fourth switch module 330 may be overlapped with at least one of the virtual lines X, Y, and Z. The second switch module **310,** the third switch module **320,** and the heat generating component **360** may be disposed to be overlapped with at least two fans in a first direction connecting the fan module **10** and the ventilation hole. The fourth switch module **330** may be disposed to be overlapped with at least one fan in a first direction connecting the fan module **10** and the ventilation hole.

The second to fourth switching modules **310, 320** and **330** may be disposed to be overlapped with one another in a first direction. Different switching modules may be disposed to not overlap each other in a second direction that is perpendicular to the first direction. Among the second to fourth switching modules **310, 320** and **330,** the closer they are disposed to the fan module **10,** the larger the size of the heat sink may be. When the second switch module **310,** the third switch module **320,** and the fourth switch module **330** are disposed sequentially from the fan module **10,** the heat sink of the second switch module **310** may be larger than the heat sink of the third switch module **320,** and the heat sink of the third switch module **320** may be larger than the heat sink of the fourth switch module **330.** Through this, the heat dissipation effect of heat being generated from each switching module can be increased.

Second capacitors **350** may be disposed on both sides of the second switch module **310.** The second capacitors **350** may be disposed in multiple rows to serve as barriers so that the air flow is concentrated on the second switch module **310.** For example, the second capacitors **350** may be disposed in two rows, but may be disposed in an alternating manner. Transformers **340** may be disposed on both sides of the third switch module **320.** The height of the transformers **340** with respect to the second substrate **301** may be formed higher than the height of the third switch module **320** so that the transformers may serve as barriers so that the air flow is concentrated on the third switch module **320.**

At least one of the first to fourth switching modules **210, 310, 320** and **330** may be disposed on an imaginary line that equally divides the substrate in half in a second direction that is perpendicular to the first direction connecting the fan module **10** and the ventilation hole. At least one of the first to fourth switching modules **210, 310, 320** and **330** may be disposed on an imaginary Y line that connects the fan disposed at the center of the fan module **10** to the ventilation hole. At least one of the first to fourth switching modules **210, 310, 320** and **330** may be disposed at the center portion of the substrate. Through this, weight imbalance of the power conversion apparatus **1000** can be prevented, and an area for circuit connection can be secured by symmetrically arranging the circuits. In addition, the heat dissipation effect can be enhanced by increasing the eddy current, and imbalance in the heat dissipation flow can be prevented.

FIG. 14 is a cross-sectional view taken along line A of FIG. 13, and FIG. 15 is a cross-sectional view taken along line B of FIG. 13. The heat generating component included in the power conversion apparatus **1000** is disposed in the central portion, and components other than the heat generating component can be disposed in a structure symmetrical up and down or left and right with respect to the heat generating component.

In the cross-sectional view of FIG. 14, the first switch module **210** and the second switch module **310** may be disposed to face each other, and the first capacitor **220** and the second capacitor **350** may be disposed to face each other. The first capacitor **220** and the second capacitor **350** may be disposed to be in contact with each other, so that the gap between the first capacitor **220** and the second capacitor **350** may be minimized. The first capacitor **220** and the second capacitor **350** may be disposed close to each other, so that the gap between the first capacitor **220** and the second capacitor **350** may be minimized. Through this, the first capacitor **220** and the second capacitor **350** can serve as a barrier, thereby inducing air circulation to be concentrated in the groove between the heat dissipation fins of the first switch module **210** and the groove between the heat dissipation fins of the second switch module **310** when the fan module **10** is in operation.

In the cross-sectional view of FIG. 15, the third switch module **320** and the inductor **240** are disposed to face each other, and a transformer **340** may be disposed on each side of the third switch module **320** and the inductor **240.** A space may be formed between the third switch module **320** and the inductor **240.** The size of the transformer **340** may be formed to correspond to the space between the first substrate **201** and the second substrate **301.** Through this, the transformer **340** may serve as a barrier, thereby inducing air circulation to be concentrated in the grooves between the heat dissipation fins of the third switch module **320** and the space between the third switch module **320** and the inductor **240** when the fan module **10** is in operation.

Referring to FIGS. 8 and 9, the fourth switch module **330** may comprise a heat sink **331,** a pad **334,** a device unit **335,** and a terminal portion **336.** The fourth switch module **330** may be an O-ring diode being connected to an output-side capacitor.

The heat sink **331** may include a base **332** on which a device unit **335** is disposed on one surface, and heat dissipation fins **333** protrudingly formed on the other surface of the base **332.** The heat sink **331** may be referred to as a heat sink. A plurality of heat dissipation fins **333** may be formed parallel to each other to form a flow path through which air may flow in a recessed area. The flow path formed between the plurality of heat dissipation fins **333** may be formed in a straight line from the fan module **10** to the ventilation hole. The plurality of flow paths formed between the plurality of heat dissipation fins **333** may be formed parallel to each other.

A pad **334** may be disposed between the base **332** and the device unit **335.** The pad **334** may be an insulating pad. The device unit **335** may be disposed on the pad **334.** Various switching elements and O-ring diodes may be mounted on the device unit **335.** The device unit **335** may have a case shape and may have various switching elements and O-ring diodes mounted therein. One surface of the device unit **335** may include a terminal portion **336** connected to the first substrate **201.** The device unit **335** may include a plurality of protruded portions, and the terminal portions **336** may be disposed on the plurality of protruded portions. The device unit **335** may include a coupling hole. The device unit **335** may be coupled to the heat sink **331** through a screw S being coupled to the coupling hole.

The transformer **340** may comprise a core **341,** a coil **342,** and a bobbin **343.**

The bobbin **343** may have a hollow shape and comprise an upper portion **3441,** a middle portion **3451,** and a lower portion **3461.** A coil **342** may be wound around the middle portion **3451.** The coil **342** may include a primary coil being wound around the middle portion **3451** and a secondary coil being wound around the primary coil. The coil **342** may include a primary coil being wound around the middle portion **3451,** adjacent to the upper portion **3441,** and adjacent to the lower portion **3461.** The core **341** may include an upper core being formed to surround the upper portion **3441** and the coil **342** of the bobbin **343,** and a lower core being formed to surround the lower portion **3461** and the coil **342.** The upper core and the lower core may be separate configurations or may be formed as a single configuration.

The upper portion **3441** of the bobbin **343** may include an upper surface being contacted with the core **341.** The bobbin **343** may comprise a protruded portion **3442** being protruded outwardly from the upper surface. The bobbin **343** may comprise a protruded portion **3442** being extended outwardly from the upper surface.

The lower surface of the protruded portion **3442** may face the coil **342.** The protruded portion **3442** may be overlapped with the coil **342** in a direction from the upper portion to the lower portion. The protruded portion **3442** may include two protruded portions **3442** being protruded from the guide wall **3444.** A fixing groove **3443** may be formed between the two protruded portions **3442.** The fixing groove **3443** may serve to support the wire terminal being extended from the coil **342** to be caught and fixed.

The outer side surface of the protruded portion **3442** may be formed in a round shape. The outer side surface of the protruded portion **3442** may be formed in a chamfer shape. The protruded portion **3442** may be formed more inward than the recessed portion **3462** of the lower portion **3461** of the bobbin **343.** The hole **3463** of the recessed portion **3462** may not be overlapped with the protruded portion **3442** in a direction from an upper portion to a lower portion. Through this, when a screw **S** is coupled to the hole **3463** of the recessed portion **3462** in a direction from an upper portion to a lower portion, interference caused by the protruded portion **3442** can be prevented.

The bobbin **343** may include a guide wall **3444** being formed between the upper surface and the protruded portion **3442.** The bobbin **343** may include a guide wall **3444** being protruded upward between the upper surface and the protruded portion **3442.** The guide wall **3444** may be formed between the upper surface and the protruded portion **3442.** The inner surface of the guide wall **3444** may be in contact with the core **341.** The inner surface of the guide wall **3444** may face the core **341.** The guide wall **3444** may serve to support the outer side surface of the core **341** to prevent the core **341** from moving or separation.

The lower portion **3461** of the bobbin **343** may include a recessed portion **3462** being formed downwardly at an edge. The lower portion **3461** of the bobbin **343** may include a recessed portion **3462** being formed downwardly at a corner. A hole **3463** penetrating the recessed portion **3462** may be formed in the recessed portion **3462.** A screw **S** may be coupled to the hole **3463** being formed in the recessed portion **3462,** and the screw **S** may be coupled to a pop nut **302** being disposed in the second substrate **301** and the second housing **30.**

Through this, the transformer **340** can be fixedly connected to both the second substrate **301** and the second housing **30.** Since the transformer **340** is a large and heavy component among the components disposed on the second assembly **300,** when it is fixed only to the second substrate **301,** the second substrate **301** may warp and damage may occur to the components being disposed on the second substrate **301.** Therefore, by doubly fixing the transformer **340** to the second substrate **301** and the second housing **30,** the transformer **340** can be stably disposed.

The lower portion **3461** of the bobbin **343** may include a guide groove **3464** being formed on the opposite side of the protruded portion **3442** of the upper portion **3441.** The lower portion **3461** of the bobbin **343** may include a guide groove **3464** being formed between two recessed portions **3462** of adjacent corners. The guide groove **3464** may include a plurality of guide grooves **3464** being spaced apart from each other. The guide groove **3464** may be overlapped with the coil **342.** The guide groove **3464** may be formed to facilitate the coil **342** winding operation.

The support member **230** being disposed in the first assembly **200** may be disposed to be in contact with the transformer **340.** The support member **230** may be disposed to be in contact with the core **341** on the upper portion side of the transformer **340.** The support member **230** may be disposed to be in contact with the transformer **340** to prevent upward movement of the transformer **340** and vertical vibration of the transformer **340.**

The support member **230** may include a first pad **231** being disposed on the first assembly **200** and a second pad **232** being disposed on the first pad **231.** The first pad **231** may be made of a plastic material or a silicone material. The second pad **232** may be made of an elastic material or a sponge material. The first pad **231** may include a hole penetrating the first pad **231.** The support member **230** may be fixed to the first assembly **200** by being screw-coupled to the hole of the first pad **231.** The screw may be fixed to the hole of the first pad **231** by being coupled with a pop nut **202** being inserted into the first housing **20.** The hole of the first pad **231** may be formed in a chamber shape. The screw being disposed on the first pad **231** may be disposed inside the hole so as not to be protruded outwardly from the first pad **231.** A second pad **232** may be attached onto the first pad **231.** An adhesive may be disposed between the first pad **231** and the second pad **232.**

Those skilled in the art related to the present embodiment will understand that the above-described description can be implemented in a modified form without departing from the essential characteristics thereof. Therefore, the disclosed methods should be considered from an illustrative rather than a restrictive perspective. The scope of the present invention is indicated by the claims, not the above description, and all differences within the scope equivalent thereto should be interpreted as being included in the present invention.

## Claims

1. A transformer comprising:
a bobbin;
a coil being wound around the bobbin; and
a core surrounding the coil and the bobbin,
wherein the bobbin comprises an upper portion, a lower portion, and a middle portion which is between the upper and lower portions and around which the coil is wound, and
wherein holes are provided in the lower portion of the bobbin.

2. The transformer according to claim 1,
wherein the lower portion of the bobbin may include a recessed portion in which the hole is formed, and
wherein the recessed portion may include a plurality of recessed portions being formed spaced apart from an edge of the lower portion of the bobbin.

3. The transformer according to claim 1,
wherein the upper portion of the bobbin includes an upper surface facing the core and a protruded portion being protruded outward from the upper surface, and
wherein the protruded portion is overlapped with the coil from the upper portion toward the lower portion.

4. The transformer according to claim 3,
wherein the hole is not overlapped with the protruded portion in a direction from the upper portion to the lower portion.

5. The transformer according to claim 1,
wherein the upper portion of the bobbin includes a guide wall being protrudedly formed between the upper surface and the protruded portion, and
wherein an inner surface of the guide wall faces the core.

6. A power conversion apparatus comprising:
a first housing;
a first substrate being disposed in the first housing; and
a transformer being disposed on the first substrate,
wherein the transformer includes:
a bobbin including a hollow portion;
a coil being wound around the bobbin; and
a core being disposed to surround the coil and the bobbin,
wherein the bobbin includes an upper portion, a lower portion, and a middle portion on which the coil is wound between the upper portion and the lower portion, and
wherein the transformer is coupled to the first housing as a screw is disposed in a hole being formed in the lower portion of the bobbin.

7. The power conversion apparatus according to claim 6,
wherein a fixing member is inserted from the outside to the inside of the first housing, and
wherein the screw being disposed in the hole of the bobbin is combined with the fixing member.

8. The power conversion apparatus according to claim 6, including:
a second housing being coupled to the first housing; and
a second substrate being disposed in the second housing,
wherein the second substrate includes a support member being disposed at a position corresponding to the transformer.

9. A power conversion apparatus according to claim 8,
wherein the support member includes a first pad being disposed on the second substrate and a second pad being disposed on the first pad, and wherein the second pad is made of an elastic material or a sponge material.

10. A power conversion apparatus according to claim 6,
wherein the upper portion of the bobbin includes an upper surface facing the core and a protruded portion being protruded outward from the upper surface, and
wherein the protruded portion is overlapped with the coil from the upper portion toward the lower portion.
